# EUROPEAN PATENT APPLICATION

(11) **EP 4 752 539 A1**
(43) Date of publication of application: **03.06.2026**
(21) Application number: 25218429.6
(22) Date of filing: 25.11.2025
(51) Int. Cl.: G01N 23/2251, H01J 37/26

(54) **DISTRIBUTIVE IMAGING ALLOWING SAMPLE RELAXATION**

(30) Priority: 27.11.2024 US 202418962841
(71) Applicant: FEI COMPANY, Hillsboro, OR 97124 (US)
(72) Inventor: SHÁNEL, Ondrej, Hillsboro, 97214 (US); MALÍNSKÝ, Milos, Hillsboro, 97214 (US); STRELEC, Petr, Hillsboro, 97214 (US)
(74) Representative: Boult Wade Tennant LLP

(57) **Abstract**

CPB images, such as images obtained by using a pulsed electron beam in an electron microscope, are acquired with pulsed exposures of fields of view (FOVs) defined in a region of interest (202) of a sample (200). Multiple exposures are configured with a time interval greater than a phonon lifetime to reduce sample damage induced by the CPB exposure. FOVs can defined to be spaced apart to control effective irradiation dose based on a combination of direct exposure and evanescent exposure.

## Description

### FIELD

The application pertains to charged-particle-beam imaging with reduced sample damage.

### BACKGROUND

Many samples of interest in electron microscope imaging are beam sensitive and are destroyed or otherwise altered in response to electron beam exposure. Such alterations can significantly change sample characteristics, limiting the usefulness of subsequent imaging. Damage can be associated with, for example, ejection or displacement of atoms, ejection of secondary electrons, or bond breaking in response to the electron beam. While damage can be to some extent mitigated by using very low beam doses, low doses typically cannot provide satisfactory image quality. Accordingly, approaches are needed that can reduce or eliminate the effects of such damage in sample images while still providing adequate image signal-to-noise ratio.

### SUMMARY

Methods and apparatus are disclosed that provide repetitive exposure of sample areas to a charged-particle beam (CPB) so that an effective exposure is controlled to avoid or reduce CPB-induced sample damage. CPB exposures can be temporally spaced so that a subsequent exposure of a sample area occurs after reversible, CPB-induced sample changes due to previous CPB exposures have dissipated or relaxed. With this relaxation, the sample area is effectively exposed only to a currently applied CPB, avoiding effects to due to combination with prior exposures. In addition, CPB exposures can be spaced apart temporally or spatially to avoid the effects of combining a current CPB exposure of a selected sample area with an evanescent exposure from a previously exposed sample area. According to the disclosed approaches, total charge such as a number of electrons applied to a sample area can be controlled to as few as one. Such limited exposures can be especially useful with samples such as frozen samples of biological materials.

The foregoing and other features, and advantages will become more apparent from the following detailed description, which proceeds with reference to the accompanying figures.

### BRIEF DESCRIPTION OF THE DRAWINGS

FIG. 1 illustrates a representative CPB imaging system that provides pulsed CPB exposure of a plurality of FOVs defined in an ROI of a sample.
FIG. 2 illustrates a set of FOVs arranged in a rectangular array of spaced-apart FOVs and corresponding FOV images responsive to pulsed CPB exposure. In FIG. 2, a particular sequence of FOV image acquisitions is illustrated.
FIGS. 3A-3B illustrate first and second rectangular arrays of spaced-apart FOVs, wherein the first and second sets are offset along an axis.
FIG. 4 illustrates a representative CPB imaging system that provides pulsed CPB exposure of a plurality of FOVs by deflecting a CPB to each of the FOVs and deflecting the associated FOV image beams along an axis of a CPB detector.
FIG. 5A illustrates a representative FOV and a perimeter evanescence region.
FIG. 5B illustrates FOVs such as shown in FIG. 5A and which have perimeter evanescence regions that are partially overlapping as exposed to CPB pulses.
FIG. 5C illustrates change in perimeter evanescence regions after exposure to a CPB.
FIG. 6 illustrates a representative method of CPB imaging using independently exposed FOVs.
FIG. 7A illustrates spaced-apart FOVs that include respective features of interest.
FIG. 7B illustrates an FOV as shown in FIG. 7A overlaid with pixels of an array detector situated to image the FOV.
FIG. 8 illustrates independently exposable FOVs with evanescent perimeters and exposed using different doses.
FIG. 9A illustrates adjacent square FOVs that are not separated by evanescent perimeter regions.
FIG. 9B illustrate overlapping exposures of FOVs with controlled doses.
FIG. 10 illustrates a representative computing environment that is adapted to control FOV exposure and image processing.

### DETAILED DESCRIPTION

### Introduction and Terminology

CPB imaging apparatus and methods as disclosed herein permit sample imaging with reduced or no contributions associated with reversible sample changes in response to CPB exposure. In the examples, sample areas are exposed to CPB pulses with pulse timings selected to allow recovery of reversible changes responsive to prior CPB exposures. In addition, CPB exposures can be arranged so that multiple sample regions are exposed, where the sample regions are separated by perimeter distances associated with evanescent coupling from exposed regions. Samples can be maintained at low temperature and CPB exposures arranged to avoid or reduce irreversible sample changes.

Many types of samples are beam-sensitive and are destroyed, damaged, or altered in response to electron beam doses of greater than 40 electrons/Å² although some samples maintained at lower temperatures (typically cryogenic temperatures of less than 100 K such as at or near liquid nitrogen boiling point of 77 K) can tolerate doses that are two or more times larger. Dose-dependent sample changes include physical, chemical, and other changes that can make post-exposure sample imaging uninformative.

As used herein, a field of view (FOV) is a region of a sample of interest which is exposed to a single pulse of a charged-particle beam (CPB). An image of the sample of interest is obtained by exposing one or more FOVs with multiple CPB pulses. As discussed below, the FOVs can be repetitively or multiply exposed to a CPB to improve signal-to-noise ratio in the FOV images. FOV area can be selected in view of available pulsed CPB beam current by, for example, selecting an FOV area so that CPB dose associated with a CPB pulse does not produce unacceptable changes in features of interest of the sample. In some cases, it is desirable to use a relatively large CPB beam current and a relatively short exposure time to produce suitable FOV images.

Some types of exposure-related effects on a FOV are not recoverable and can depend on total dose or total exposure energy, while other exposure-related effects disappear or diminish as a function of time after exposure. Irrecoverable changes can be associated with so-called knock-on displacements in which atoms in a sample are ejected or displaced by exposure. Recoverable changes can be associated with ejection of secondary electrons, sample charging, and, in some cases, bond breakage. However, the approaches disclosed herein do not rely on any particular mechanisms of reversible or irreversible changes.

As used herein, "FOV relaxation time" or "relaxation time" *tᵣₑₗₐₓ* is a time interval from a time of an exposure of an FOV to a CPB pulse to a time associated with sample recovery from recoverable changes produced by the CPB exposure. FOV relaxation time is also associated with a time interval after a CPB exposure at which a subsequent CPB exposure produces sample changes that do not depend upon the previous CPB exposure, disregarding irrecoverable changes produced by a first exposure. The sample can be considered to have returned to a pre-exposure state and effects of a subsequent CPB exposure do not depend on a previous exposure except to the extent that the previous exposure produced irrecoverable changes. The relaxation time *tᵣₑₗₐₓ* may be associated with a lifetime of phonons produced by CPB exposure which is typically between 1 µs and 10 µs.

Exposure of a FOV to a CPB also produces an FOV perimeter region that is referred to herein as an "effectively exposed region" based on evanescent CPB effects from the associated exposed FOV. The evanescence exposure is to be contrasted with exposure resulting from charged particles incident to the region which can be referred to as "direct" exposure. The effective exposure dissipates with an evanescence time constant which is typically much shorter than the FOV relaxation time. In order to reduce sample changes in response to CPB exposure, these perimeter areas are considered to have been effectively exposed when the associated FOVs are exposed. For this reason, FOVs to be exposed can be spaced apart in consideration of the extent of such effectively exposed regions to avoid applying excess CPB dose to the perimeter regions. Alternatively, subsequent exposures can be temporally spaced based on an evanescence relaxation time. As used herein, a distance associated with evanescent exposure is referred to as *Lₑᵥ* and FOVs that are adjacent and exposed sequentially can be spaced apart by this distance to avoid or reduce CPB-induced sample changes. Evanescent exposure tends to decay much more rapidly than the relaxation time *tᵣₑₗₐₓ* and persists for times of less than 1 ns so that the evanescent exposure is generally a consideration only for FOVs that are exposed sequentially within less than 5-10 ns. The evanescence distance *Lₑᵥ* is a function of time after exposure and rapidly decays to zero.

"Dose" refers to charge/area or energy/area associated with CPB exposures. Sample response to any CPB dose is a function of both total charge (a product of CPB pulse duration and CPB beam current), CPB beam energy, CPB current, and CPB pulse duration. For convenience in the description, sample alterations in response to CPB exposure are referred to as dose-dependent.

In some examples, FOV exposures and the associated images are paired with a "time stamp" or other indicator that permits assembly of the FOV images into a larger image of the sample ROI. For FOVs that are obtained by raster scanning of the CPB, the sequence of FOV images can be assembled based on a number of FOVs in a row and a number of scan rows and other position indicators are not required. In some cases, FOVs are arbitrarily selected and an indication of CPB (and FOV) at particular times is needed.

Beam or radiation beam refers to propagating charged particles or propagating electromagnetic radiation, whether collimated or uncollimated. In some examples, FOVs are arranged in rectangular arrays of rows and columns. Arrangements described with respect to columns or rows can be similarly provided with using columns and rows, respectively.

FOV image beam as used herein refers to radiation responsive to CPB exposure of an FOV which can be focused to form an image of the FOV at a detector. Such FOV image beams can be focused or unfocused at various locations in a CPB optical system and can be referred to as propagating along an axis whether or not focused.

Various FOV shapes and sizes can be used and CPB pulse durations can be varied. FOV shapes and sizes for various FOVs can be differ and doses applied to each FOV can differ as well. CPB pulse durations of less than 1 ns, 10 ns, 100 ns, 1 µs, 10 µs, 100 µs ,1 ms or others can be used. A number of CPB pulses applied to each FOV can be varied, typically ranging from 2 to 10⁹ or more, depending on beam current and a desired number of charges to be applied to each pixel area. FOV dimensions can be a few tenths of a nanometer, a few micrometers, or other large or smaller sizes. FOVs can be square, rectangular, polygonal, elliptical, circular or other shapes having arbitrary combinations of curved and linear sides.

CPB pulses can be selected to provide as few as 1, 2, 5, 10, or 20 charged particles in each pulse and acceptable image signal to noise achieved by combining or averaging FOV images from the multiple exposures. In typical examples, CPBs are electron beams and imaging systems are electron microscopes.

In some examples, ultra-short electron pulses containing no more than 10,000, 1,000, 100, 50, 25, 10, 5, or 2 electrons are applied to avoid sample damage. The electron pulses are shifted to different FOVs with a scanning deflection system so that the FOVS are separated a distance greater than 5, 2, 1, 0.5, or 0.25 times *Lₑᵥ.*

As used in this application and in the claims, the singular forms "a," "an," and "the" include the plural forms unless the context clearly dictates otherwise. Additionally, the term "includes" means "comprises." Further, the term "coupled" does not exclude the presence of intermediate elements between the coupled items.

The systems, apparatus, and methods described herein should not be construed as limiting in any way. Instead, the present disclosure is directed toward all novel and non-obvious features and aspects of the various disclosed embodiments, alone and in various combinations and sub-combinations with one another. The disclosed systems, methods, and apparatus are not limited to any specific aspect or feature or combinations thereof, nor do the disclosed systems, methods, and apparatus require that any one or more specific advantages be present or problems be solved. Any theories of operation are to facilitate explanation, but the disclosed systems, methods, and apparatus are not limited to such theories of operation.

Although the operations of some of the disclosed methods are described in a particular, sequential order for convenient presentation, it should be understood that this manner of description encompasses rearrangement, unless a particular ordering is required by specific language set forth below. For example, operations described sequentially may in some cases be rearranged or performed concurrently. Moreover, for the sake of simplicity, the attached figures may not show the various ways in which the disclosed systems, methods, and apparatus can be used in conjunction with other systems, methods, and apparatus. Additionally, the description sometimes uses terms like "produce" and "provide" to describe the disclosed methods. These terms are high-level abstractions of the actual operations that are performed. The actual operations that correspond to these terms will vary depending on the particular implementation and are readily discernible by one of ordinary skill in the art.

In some examples, values, procedures, or apparatuses are referred to as "lowest", "best", "minimum," or the like. It will be appreciated that such descriptions are intended to indicate that a selection among many used functional alternatives can be made, and such selections need not be better, smaller, or otherwise preferable to other selections.

As used herein, "image" refers to a displayed view of a sample or portion of a sample such as presented on a display device as well as stored data that can be used to produce displayed images such as digital data stored in non-transitory computer readable media as, for example, JPG, TIFF, BMP files or other formats.

### Example 1

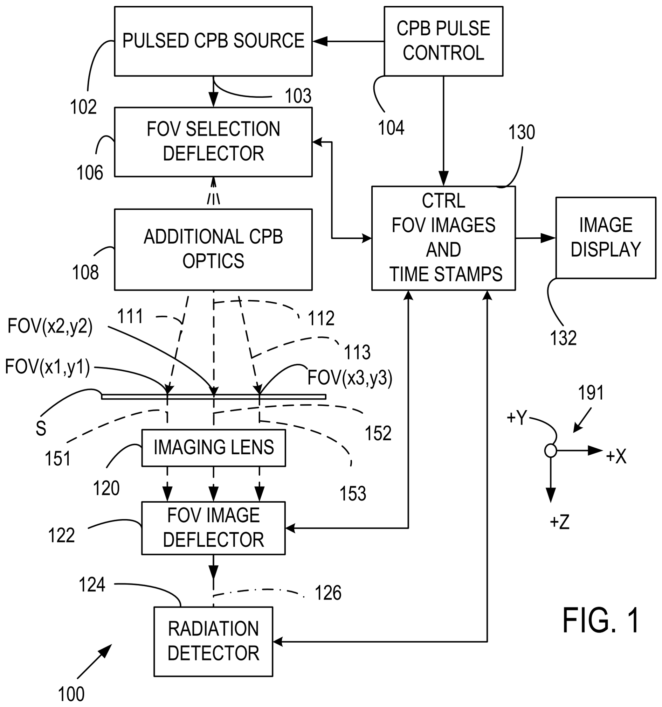

Referring to FIG. 1, a representative CPB imaging apparatus 100 includes a pulsed CPB source 102 that is operable to produce CPB pulses in response to a CPB pulse controller 104. The CPB source 102 directs a pulsed CPB 103 to a field-of-view (FOV) deflector 106 that is operable to deflect the pulsed CPB 103 to some or all FOVs on a sample S. For convenient illustration, the CPB 103 is illustrated as deflected along axes 111-113 to FOV(x1,y1), FOV(x2,y2), FOV(x3,y3), respectively, wherein x,y coordinates are defined with respect to a coordinate system 191. A CPB optical column 108 can include CPB lenses, deflectors, stigmators, apertures, or other CPB optical elements that shape, focus, and direct the deflected CPB to various FOVs. The particular arrangement of FIG. 1 is only an example, and elements of the CPB optical column 108 and the FOV deflector 106 can be arranged in different orders along a CPB optical axis 126.

A CPB imaging lens 120 is situated to receive radiation beams 151-153 associated with CPB exposure of FOV1-FOV3, respectively, and direct the radiation beam 151-153 to an FOV image deflector 122 that is configured to direct the radiation beams 151-153 along a CPB optical axis 126 to a radiation detector 124. The radiation beams 151-153 can comprise some or all of transmitted or scattered portions of the CPB, secondary emission such as secondary electrons, or photons and the radiation detector 124 can be selected accordingly. In some examples, an FOV image deflector is not used and the imaging lens 120 is sufficient to direct the radiation beams 151-153 to the radiation detector 124.

A controller 130 is coupled to the CPB pulse controller 104, the FOV selection deflector 106, and the FOV image deflector 122 to control irradiation of selected sets or sequences of FOVs and direct radiation responsive to the FOV irradiation to the radiation detector 124. The controller 130 can select FOVs randomly, as a set of rastered FOVs, or other selection in consideration of FOV relaxation time and with FOV separations in consideration of effectively exposed perimeter regions. Generally, a particular FOV is re-irradiated only after a time greater than or equal to the FOV relaxation time has elapsed. If adjacent or proximate FOVs are to be irradiated sequentially, the controller selects CPB deflection so that the FOVs are separated based on a dimension of the effectively exposed perimeter region. The controller 130 typically assembles FOV images to produce one or more images of the ROI for display on a display device 132 but can, instead of or in addition to, communicate ROI images and/or the FOV images for remoted display and processing via a network or other connection.

### Example 2

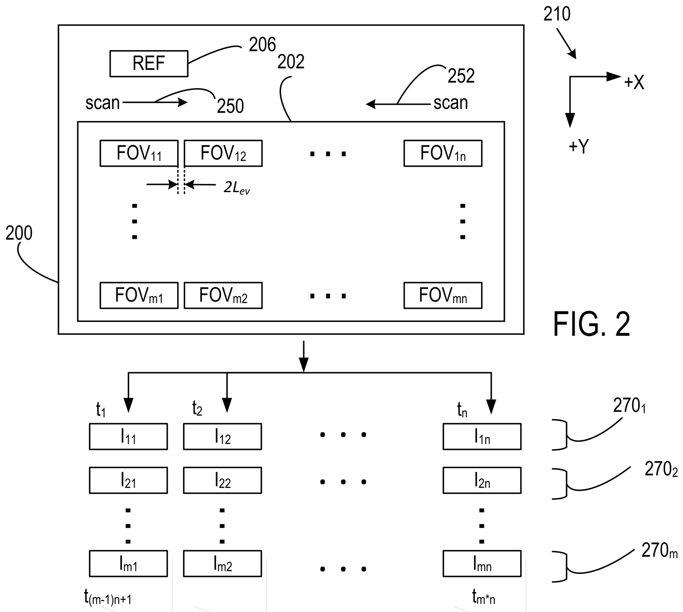

Referring to FIG. 2, a surface of a sample 200 defines a region of interest (ROI) 202 that is divided into multiple FOVs illustrated as an *m* by *n* array of FOVs FOV(*i,j*), wherein *i =* 1, . . . , *m* and *j* = 1, . . . , *n*, wherein *m* and *n* are integers greater than 0. A region 206 is selected as a reference region and can be used to establish CPB deflections for selection of FOVs, measurement of CPB beam current, CPB pulse width, or other uses. The FOVs can be irradiated row-by-row by, for example, irradiating a first row of FOVS FOV(1,1), FOV(1,2), ..., FOV(1,n) sequentially followed by irradiation of a second row of FOVs FOV(2,1), FOV(2,2), ..., FOV(2,n) beginning with either FOV(2,1) or FOV(2,n). FOVs can thus be scanned for irradiation in a single direction 250 or by alternating scanning in the direction 250 and a direction 252. In the example of FIG. 2, the FOVs in a row are spaced apart a distance 2 *L_{eff}* in an X-direction of a coordinate system 210, wherein *L_{eff}* is the effective exposure length associated with the exposures of the FOVs. The rows of the array of FOV can be similarly spaced apart. As the effective exposure length generally decays rapidly, for image acquisition using single direction scanning, scanning of an FOV such as FOV(1,1) can be temporally separated from scanning of the adjacent FOV(2,1) sufficiently so that spacing rows apart based on *L_{eff}* is unnecessary.

An image is acquired corresponding to each FOV. In FIG. 2, images *I* of representative FOVs are shown. For example, a set 270₁ of images *I*(1,1), *I*(1,2),..., *I*(1,*n*) is associated with a first row of FOVS, a set 270₂ of images *I*(2,1), I(2,2), ..., *I*(2,*n*) is associated with a second row of FOVS, and a set 270ₘ of images *I*(*m*,1), *I*(*m*,2), . . ., *I(m,n)* is associated with an *m*^{th} row of FOVS. Each of the sets 270 of images can be acquired repetitively to improve image quality, with each of exposure of an FOV temporally separated based on FOV relaxation time. In one example, images *I*(1,1), *I*(1,2), *. . ., I*(*m,n*) are obtained sequentially at respective times *t*₁*, t*₂*,* . . . , *t*₍*ₘ₋₁₎ₙ₊₁ , .* . *., t_{m*n}.* This imaging sequence can be repeated until a satisfactory image is obtained for some or all FOVs. Other orders of image acquisition can be used, such as random selection of FOVs, or sequential along column directions or along directions that are parallel to neither row nor columns.

### Example 3

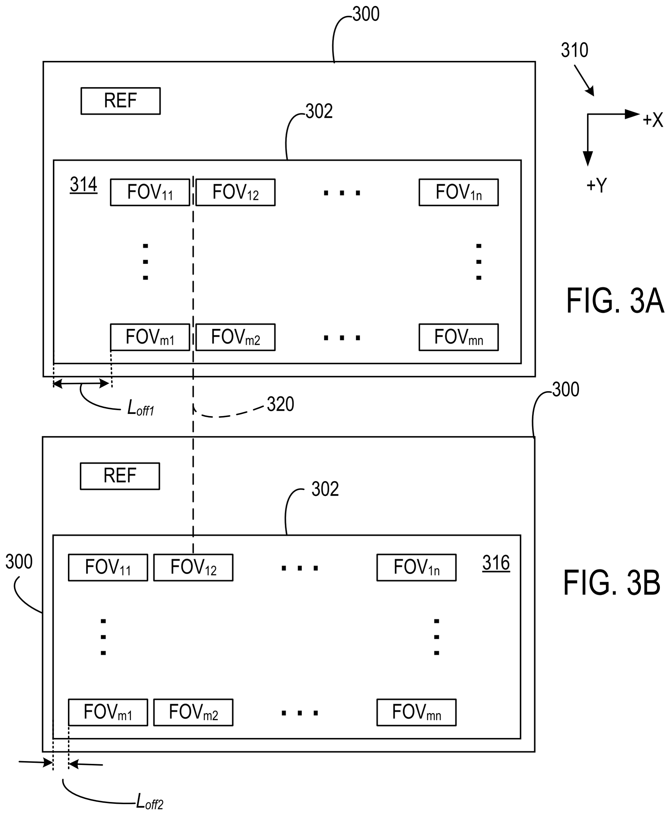

In some cases, spacing FOVs apart can result in portions of an ROI being inadequately or totally unimaged. The spaces between FOVs can be imaged as shown in the example of FIGS. 3A-3B. Referring to FIG. 3A, as in FIG. 2, an ROI 302 of sample 300 is divided into a first set 314 of FOVs which are arranged as an *m* by *n* array of FOVs, wherein each of the FOVs is spaced apart from FOVs in adjacent rows and/or columns. As shown in FIG. 3A, a first column of FOVs (and the first set 314) is offset from a reference location by a distance *L_{off1}.* To avoid gaps in an image produced by imaging the FOVs of the first set 314, as shown in FIG. 3B, a second set 316 of FOVs that is offset by a distance L*_{off2}* is defined, wherein the second set 316 of FOVs has FOVs that are situated between corresponding FOVs of the first set of FOVs. In this example, a center of a FOV in a second column of the second set 316 of FOVs is aligned on an axis 320 that is parallel to an X-axis of a coordinate system 310 and equidistant from FOVs of the first and second columns of the first set 314 of FOVs. Other offsets between first and second sets can be used, such as distance corresponding to the separation of the FOVs in each row. In general, any offset can be used that provides CPB exposure to all portions of an ROI. Multiple sets of two, three, or more FOVs can be used and the sets of FOVs need not have the same spacings in X- or Y-directions or use a common FOV size. Offsets in both row and column directions can be provided and column offset is shown for convenient illustration.

It will be appreciated that FOVs to be imaged can arranged in arrays other than rectangular arrays or can be arranged randomly or arbitrarily about an ROI. For sufficiently long time intervals between successive irradiations of the FOVs, the FOVs need not be spaced apart. FOVs defined by an array need not be imaged sequentially. The examples of FIG. 2 and 3A-3B are provided for convenient illustration. In some cases, it is more convenient to scan row of FOVs in a rectangular array in alternating directions to avoid delays associated with scanning a CPB back towards a first side of an ROI.

### Example 4

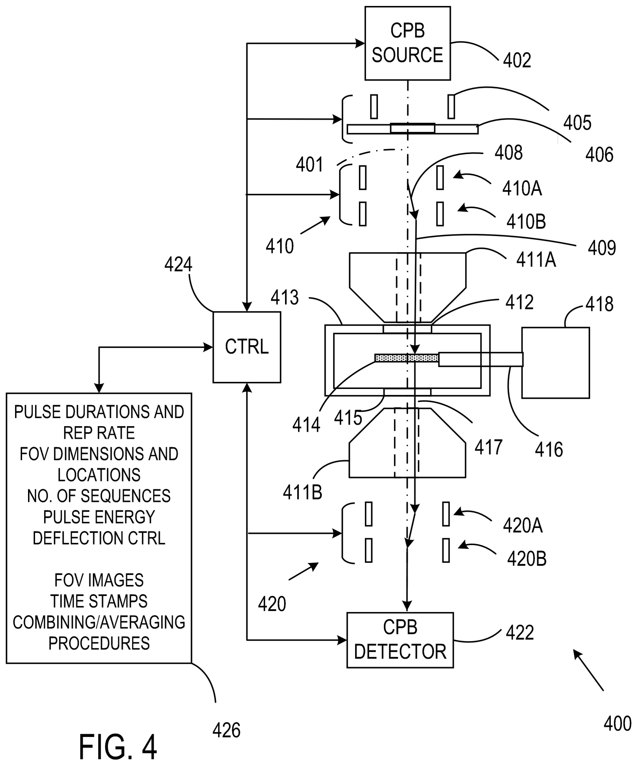

Referring to FIG. 4, a representative CPB imaging apparatus 400 includes a CPB source 402 situated to direct a CPB beam along an axis 401. A CPB beam deflector 405 is situated to selectively deflect the CPB beam to be transmitted or blocked at an aperture plate 406 to produce CPB pulses. In some examples, a pulsed CPB source is used such a photoemissive surface in combination with a pulsed laser and the CPB beam deflector is not needed. An FOV selection deflector 410 receives the pulsed CPB and includes a first deflector 410A that produces a CPB 408 that propagates away from the axis 401 and a second deflector 410B that redirects the deflected CPB from the first deflector 410A to propagate parallel to the axis 410 as a redirected beam 409. The redirected beam 409 is coupled through a first pole piece 411A of magnetic objective lens to an FOV on a sample 414. The sample 414 is retained in an enclosure 413 that includes CPB apertures 412, 415 and is thermally coupled to a cold finger 416 to establish a sample temperature such as a cryogenic temperature and to a sample stage 418 for positioning with respect to the axis 401. A radiation beam 417 such as transmitted charged particles or secondary electrons responsive to a dose applied to the FOV is coupled by a lower pole piece 411B to a FOV image beam deflector 420 that includes a first deflector 420A and a second deflector 420B that direct the radiation beam 417 to propagate parallel to the axis 401 and be at normal incidence and centered on a CPB detector 422. Such an FOV image beam deflector is not necessary but can permit use of a smaller CPB detector and provide more uniform detection of radiation beams as FOV location is varied. Selection of CPB deflections, scan rates, currents, FOV size, FOV location, FOV shape, exposure delays, repetition rates as well as FOV image averaging and combined can be provided by a controller 424 such as CPU or other processing device based on processor executable instructions and associated input and output data that can be stored in one or more non-transitory processor readable storage media or devices 426.

### Example 5

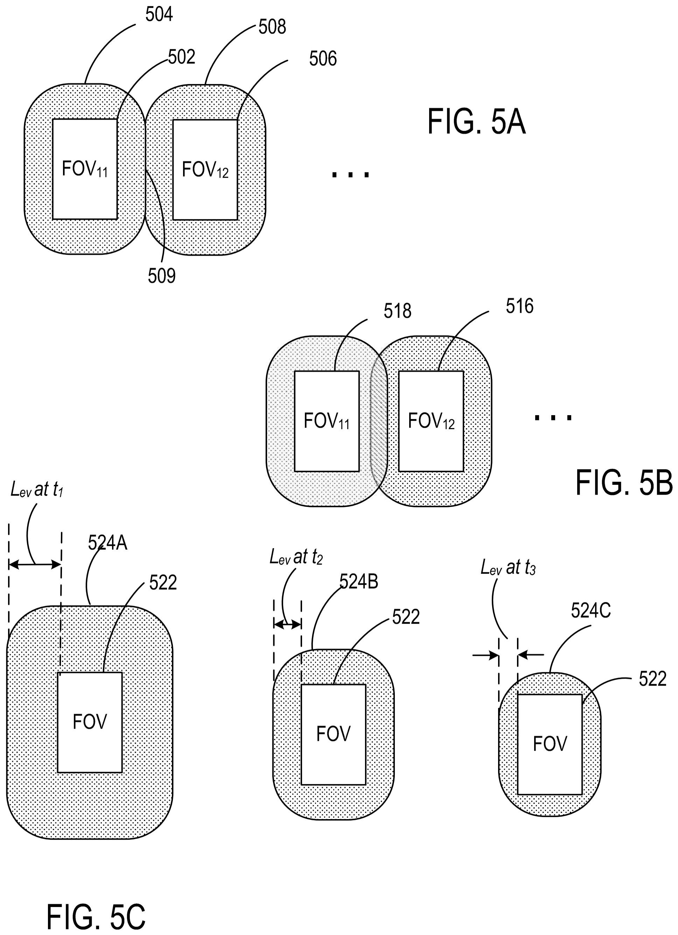

FIG. 5A illustrates FOVs 502, 506 that have a corresponding perimeter region 504, 508 associated with an evanescence distance based on CPB exposure. In the example of FIG. 5A, the perimeter regions 504, 508 share a border 509 at some time after CPB exposure. The extent of the perimeter regions 504, 508 diminishes as a function of time after CPB exposure. The perimeter regions 504, 508 are effectively exposed by respective CPB exposures and in this example, additional CPB exposure of either FOV does not interact with exposure of the other FOV to produce damage within the FOVs or their respective perimeter regions. Because perimeter region extent is a function of time, the perimeter regions 504, 508 can have different extents and still share the border 509. FIG. 5B illustrate FOVs 516, 518 having perimeter regions that partially overlap in view of weak evanescent coupling but in which multiple effective exposures of the FOVs are not associated with sample changes. FIG. 5C shows shrinking of perimeter regions 524A-524C about a FOV 522 as a function of increasing times *t₁, t₂,* and *t₃* after CPB exposure. As shown, the evanescence regions 524A-524C extend distance *Lₑᵥ* that are functions of time from CPB exposure.

### Example 6

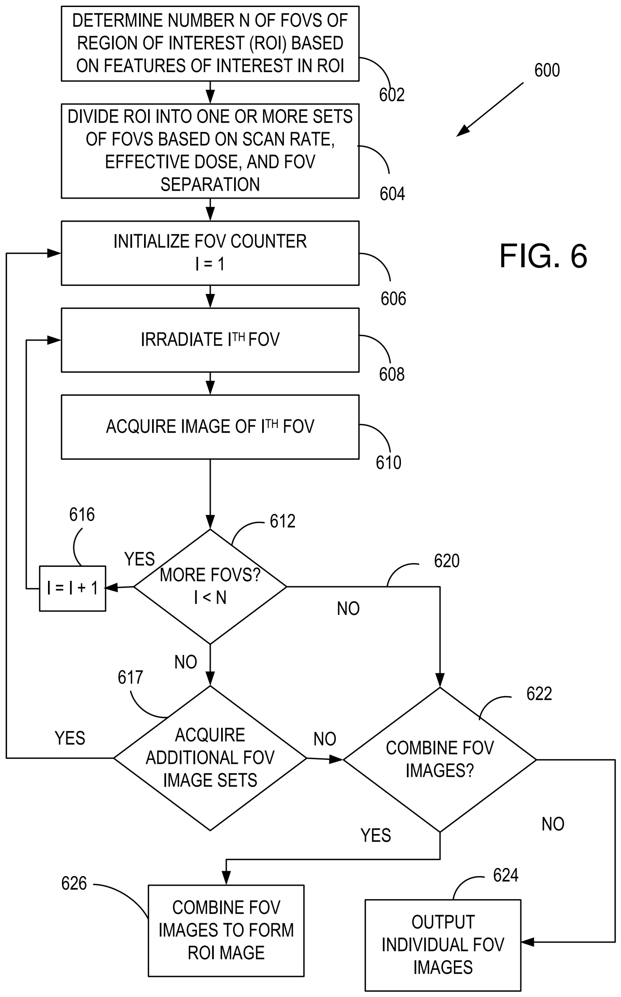

With reference to FIG. 6, a representative method 600 includes determining a number of FOVs in an ROI at 602. Typically, FOVs are selected by examining an image of an ROI to identify any features of interest and selecting an FOV for each of the features of interest. At 604, the ROI is divided into one or more set of FOVs and exposure sequencing determined to establish scan rate, effective dose, and FOV separation. At 606 a counter *I* is initialized and at 608 an *I*^{th} FOV is irradiated and an image of an *I*^{th} FOV acquired at 610. If more FOV images are to be acquired as determined at 612, the counter *I* is incremented at 616 and a subsequent FOV is irradiated and imaged. Each FOV can be exposed once or multiple times to provide a satisfactory FOV image. If all FOVs of a set have been imaged, it is determined if additional sets of FOV images are to be acquired to provide acceptable image signal-to-noise ratios at 617. If additional sets of FOV images are to be acquired, the counter *I* is reinitialized at 606 to begin acquisition of a subsequent set of FOV images. It can be determined at 622 if FOV images are to be combined, and if desired, the FOV images are combined at 626 to form an ROI image (or an image of a portion of an ROI) larger than an FOV. Alternatively, in many examples, FOVs are not proximate and individual FOV images are provided at 624. As discussed above, in most cases, numerous images of each FOV are obtained to provide an averaged FOV image with sufficient image signal-to-noise ratio.

In the example of FIG.6, multiple FOVs are imaged one after another and then reimaged repetitively to achieve satisfactory image quality. During exposure of one FOV, CPB effects in previously exposed FOVs diminish as discussed above. However, each FOV can be exposed repeatedly before switching to other FOVs.

### Example 7. Selective Imaging of ROIs

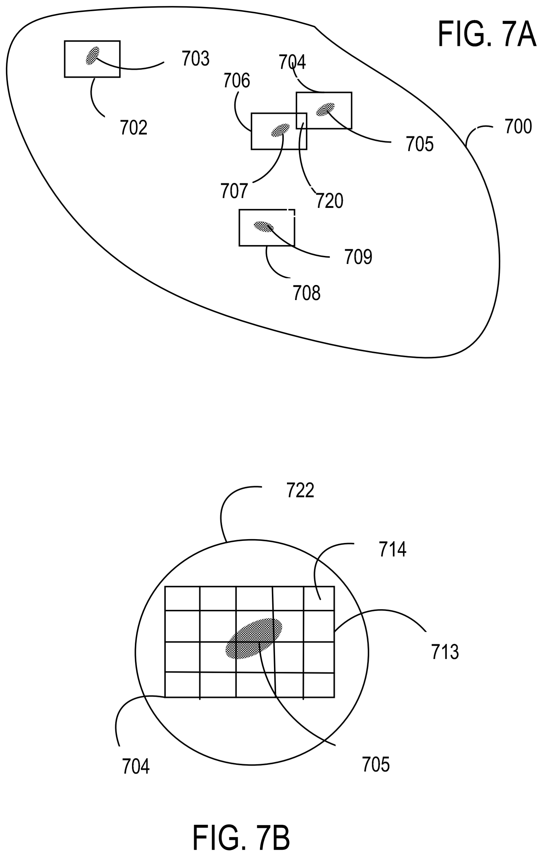

In typical practical examples, only selected FOVs of a much larger ROI are of interest. Referring to FIG. 7A, a ROI 700 includes FOVs 702, 704, 706, 708 that are to be imaged to investigate features of interest 703, 705, 707, 709, respectively. The FOVs are shown as rectangular areas that can be selected to be imaged to pixels of a rectangular detector array based on imaging system magnification. In the example of FIG. 7A. the FOVs 704, 706 define an overlap area 720 but in most cases, such overlap areas can receive radiation without concerns about damage as they contain no features of interest or are unlikely to do so for most samples. However, if desired, CPB exposures can be arranged to allow sufficient relaxation in areas such as these to avoid beam-induced sample damage.

The FOV 704 is shown enlarged in FIG. 7B overlaid to indicate mapping to pixels 713 of a detector array such as representative pixel 714. Some pixel sizes of interest are 1 Å by 1 Å, 2 Å by 2 Å, 5 Å by 5 Å, 10 Å by 10 Å, 20 Å by 20 Å, 50 Å by 50 Å, or other sizes. A 4 by 5 pixel array is illustrated but in general an M by N array is used, wherein M and N are integers, with typical values in a range of 100 to 5000. In some examples, a 2000 by 2000 array (4 Mpixels) is used. A CPB such as an electron beam can irradiate an area 722 shown as circular for convenience. Electron beam intensity is selected so that during any electron beam pulse, no area of a FOV corresponding to a pixel receives more than a single electron to avoid damage or degradation of the features of interest. Pulses with single electrons can be used and repeated until FOV areas associated with all pixels have received enough electrons to provide an adequate FOV image signal-to-noise ratio. To provide a single electron exposure of each pixel of a pixel array, a maximum number of electrons is equal to the number of pixels; pulse charges greater than this will have more than one electron per FOV area associated with a pixel. Thus, a number of electrons per pulse ranges for 1 electron/pulse to MN electrons/pulse. However, for numbers of electrons/pulse that approach the upper limit MN, it becomes probable that some FOV areas associated with pixels will receive more than one electron while others will receive none. Electrons/pulse can be selected based on the likelihood of multiple electrons in a pixel area as well as to maintain spacing between exposed pixels to avoid coupling via evanescent exposure.

Charge/pulse is a significant factor in establishing an imaging time. Other factors include a preferred number of electrons associated with each pixel and a relaxation time. An imaging time T_{image} when using single electron pulses that are applied repetitively and sequentially for each pixel of of an M by N array pixels such that each pixel is responsive to irradiation by one pulse during a relaxation time *tᵣₑₗₐₓ* with pulses repeated so that each pixel is associated with (on average) Q charges, wherein M, N, Q are non-negative integers is T_{image} = QMN*tᵣₑₗₐₓ.* For a 4 Mpixel detector array and Q = 40 electrons//pixel with *tᵣₑₗₐₓ =* 10 µs, T_{image} = 1600 s. For per pulse charge at the upper limit of single charge/pixel (i.e., MN electrons/pulse), each FOV area associated with a pixel receives an electron during each pulse so that the total imaging time T_{image} = *Qtᵣₑₗₐₓ,* or 400 µs using the Q = 40 and *tᵣₑₗₐₓ =* 10 µs. However, at such high numbers of electrons/pulse, many FOV areas associated with pixels are likely to receive multiple electrons in a single pulse, and smaller numbers of electrons/pulse would generally be preferred.

Referring again to FIG. 7A, imaging of the FOVs 702, 704, 706, 708 can be done by sequentially directing a CPB to each of the FOVs or by imaging selected FOVs before imaging the remaining FOVs. By sequential imaging, times between imaging each FOV can be used to provide some or all of the relaxation time for subsequent irradiation without sample damage.

### Example 8

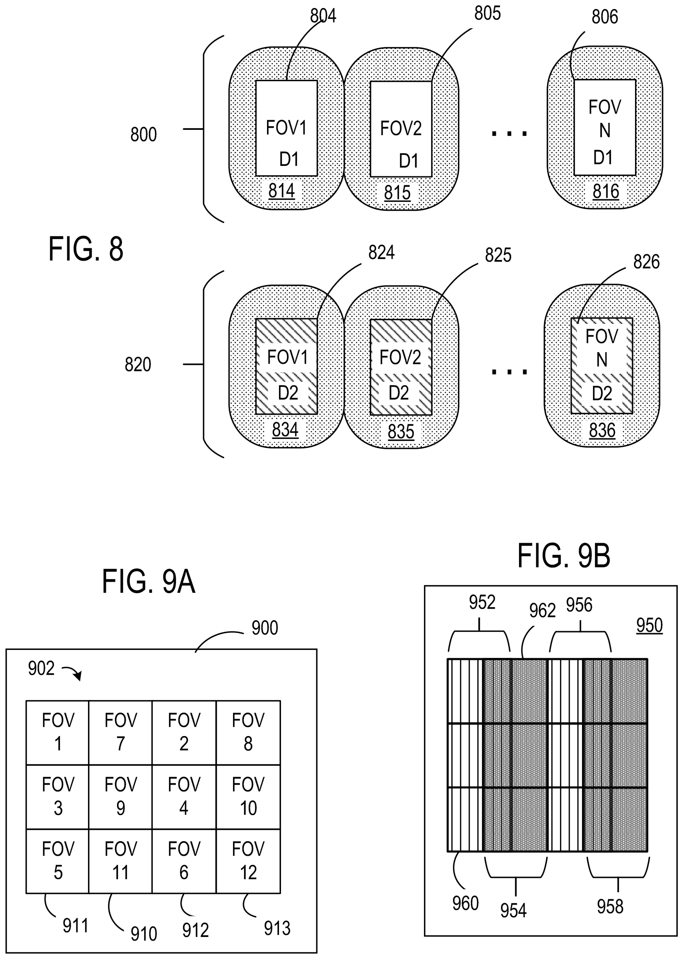

FIG. 8 illustrates a first set 800 of *N* FOVs and a second set 820 of N FOVs that are exposed to CPB doses D1, D2, respectively, wherein N is a positive integer. Representative FOVs 804-806 of the first set 800 have surrounding evanescence regions 814-816; representative FOVs 824-826 of the second set 820 have surrounding evanescence regions 834-836. Some or all FOVs can receive different CPB dose, and rows or columns of FOV in rectangular arrays need not receive a common doses. For some samples, selected FOVs can be more or less sensitive to CPB exposure or exposure parameter such as pulse duration, CPB current, CPB energy or other and CPB pulses can be configure appropriately (and individually) for each FOV. In some examples, selected FOVs are of lesser importance and fewer CPB pulses are applied to speed FOV image acquisition.

### Example 9

FIGS. 9A-9B illustrate additional arrangements of FOVs and methods of irradiating and imaging FOVs. FIG. 9A illustrates an array of FOVs defined in an ROI of a sample 902, wherein the FOVs contact adjacent FOVs, without separation based on evanescent exposure. In this example, the FOVs are labeled from 1 to 12 to indicate an order of exposure so that an adjacent FOV is not exposed immediately before or after exposure of any FOV. For example, FOV 910 noted as exposed 11^{th} is adjacent FOVs 911, 912 that are exposed 5^{th} and 6^{th}, respectively, so that, depending on a time constant associated with evanescent exposure, FOV separation is not provided. Similarly, FOV 912 is exposed 6^{th}, well before exposure of FOVs 911, 913. The FOVs of FIG. 9A are illustrated as exposed in a particular order, but other orderings can be used such as random selection of FOVs, subject to the constraint that a time between multiple exposures is based on an FOV relaxation time as discussed above.

FIG. 9B illustrates a set 960 of FOVs defined on a substrate 950. In this example, the FOVs are defined in columns 952, 956 and columns 954, 958, wherein the FOVs of the columns 952, 956 overlap with the FOVs of the columns 954, 958. In this example, FOV overlap is permitted but such double exposure of an overlapping region of any FOVs, additional exposure is delayed based on an FOV relation time. Multiple FOV overlaps can be used based on suitable CPB exposure delays to allow FOV relaxation. In some examples, exposure of only selected FOVs is subjected to delay based on FOV relaxation while FOVs are not.

### Example 10. Representative Computing Environment

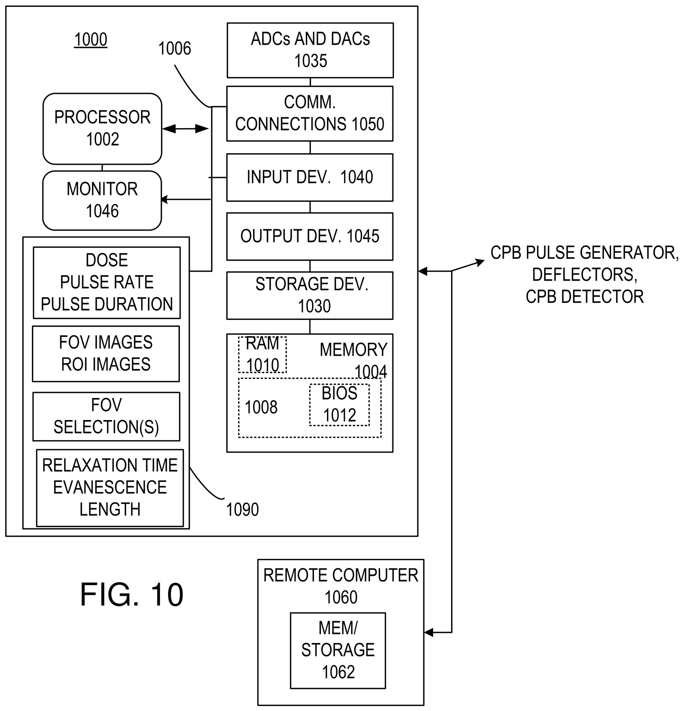

FIG. 10 and the following discussion are intended to provide a brief, general description of an exemplary computing environment in which the disclosed technology may be implemented. In particular, some or all portions of this computing environment can be used with the above methods and apparatus to define a controller or control system to, for example, control beam deflections, FOV selection, pulse rate, FOV dose, and process FOV and ROI images. Although not required, the disclosed technology is described in the general context of computer executable instructions, such as program modules, being executed by a personal computer (PC). Generally, program modules include routines, programs, objects, components, data structures, etc., that perform particular tasks or implement particular abstract data types. Moreover, the disclosed technology may be implemented with other computer system configurations, including hand-held devices, tablets, multiprocessor systems, microprocessor-based or programmable consumer electronics, network PCs, minicomputers, mainframe computers, and the like. The disclosed technology may also be practiced in distributed computing environments where tasks are performed by remote processing devices that are linked through a communications network. In a distributed computing environment, program modules may be located in both local and remote memory storage devices. In some cases, such processing is provided remotely while in others and more typically, in a dedicate microscope system. The disclosed systems can serve to control image acquisition and provide a user interface as well as serve as an image processor.

With reference to FIG. 10, an exemplary system for implementing the disclosed technology includes a general purpose computing device in the form of an exemplary conventional PC 1000, including one or more processing units 1002, a system memory 1004, and a system bus 1006 that couples various system components including the system memory 1004 to the one or more processing units 1002. The system bus 1006 may be any of several types of bus structures including a memory bus or memory controller, a peripheral bus, and a local bus using any of a variety of bus architectures. The exemplary system memory 1004 includes read only memory (ROM) 1008 and random access memory (RAM) 1010. A basic input/output system (BIOS) 1012, containing the basic routines that help with the transfer of information between elements within the PC 1000, is stored in ROM 1008.

The exemplary PC 1000 further includes one or more non-transitory storage devices 1030 such as a hard disk drive for reading from and writing to a hard disk, a magnetic disk drive for reading from or writing to a removable magnetic disk, and an optical disk drive for reading from or writing to a removable optical disk .Such storage devices can be connected to the system bus 1006 by a hard disk drive interface, a magnetic disk drive interface, and an optical drive interface, respectively. The drives and their associated computer readable media provide nonvolatile storage of computer-readable instructions, data structures, program modules, and other data for the PC 1000. Other types of computer-readable media which can store data that is accessible by a PC, may also be used in the exemplary operating environment.

A number of program modules may be stored in the storage devices 1030 including an operating system, one or more application programs, other program modules, and program data. A user may enter commands and information into the PC 1000 through one or more input devices 1040 such as a keyboard and a pointing device such as a mouse. For example, the user may enter commands to initiate image acquisition or select FOVs, ROIs, dose, time constants associated with evanescence and FOB relaxation. These and other input devices are often connected to the one or more processing units 1002 through a serial port interface that is coupled to the system bus 1006, but may be connected by other interfaces such as a parallel port, universal serial bus (USB), or wired or wireless network connection. A monitor 1046 or other type of display device is also connected to the system bus 1006 via an interface, such as a video adapter, and can display, for example, one or more FOV image or ROI images or other raw or processed images used for alignment and selection of FOVs and ROIs. Other peripheral output devices, such as speakers and printers (not shown), may be included.

The PC 1000 may operate in a networked environment using logical connections to one or more remote computers, such as a remote computer 1060. In some examples, one or more network or communication connections 1050 are included. The remote computer 1060 may be another PC, a server, a router, a network PC, or a peer device or other common network node, and typically includes many or all of the elements described above relative to the PC 1000, although only a memory storage device 1062 has been illustrated in FIG. 10. The personal computer 1000 and/or the remote computer 1060 can be connected to a logical a local area network (LAN) and a wide area network (WAN). Such networking environments are commonplace in offices, enterprise-wide computer networks, intranets, and the Internet. In some examples, a stack of aligned image is transmitted to a remote system for 3D image reconstruction or other processing.

As shown in FIG. 10, a memory 1090 (or portions of this or other memory) store processor executable instructions to control CPB deflectors, CPB pulse repetition rate, CPB pulse duration, FOV parameters such as size, shape, separation, FOV dose, and to acquire FOV images and assemble FOV images to form an ROI images as well as storing the associated exposure data, image data, relaxation times, evanescence lengths. FOV images can be stored with a time stamp (or other indication of FOV image order) that indicates when the FOV image was acquired so that the FOVs can be assembled into an FOV image.

### Disclosure Paragraphs

Example 1 is a method, including: applying multiple CPB pulses to at least one field of view (FOV) defined in a region of interest (ROI) of a specimen, wherein the multiple CPB pulses are applied to the at least one FOV with a temporal separation based on an FOV relaxation time; and obtaining multiple FOV images of the at least one FOV, each FOV image correspond to a respective CPB pulse of the multiple CPB pulses.

Example 2 includes the subject matter of Example 1, and further specifies that the at least one FOV is defined based on a portion of an image of the ROI of the specimen that contains a feature of interest.

Example 3 includes the subject matter of any of Examples 1-2, and further specifies that the at least one FOV is two or more FOVs defined based on portions of an image of the ROI of the specimen that include respective features of interest.

Example 4 includes the subject matter of any of Examples 1-3, and further includes combining the FOV images associated with each of the multiple CPB pulses to produce a combined FOV image.

Example 5 includes the subject matter of any of Examples1-4, wherein the FOV images are combined by averaging or summing to produce the FOV image.

Example 6 includes the subject matter of any of Examples 1-5, wherein the multiple CPB pulses are applied to the at least one FOV are temporally separated by at least the FOV relaxation time.

Example 7 includes the subject matter of any of Examples 1-6, and further specifies that the FOV relaxation time is a phonon relaxation time.

Example 8 includes the subject matter of any of Examples 1-7, and further includes applying CPB deflections to produce the multiple CPB pulses.

Example 9 includes the subject matter of any of Examples 1-8, and further includes applying image deflections to FOV image beams associated with the FOV images, the image deflections selected to direct each of the FOV image beams along a detector axis.

Example 10 includes the subject matter of any of Examples 1-9, and further specifies that the at least one FOV is two or more FOVs defined based on portions of an image of the ROI of the specimen that include respective features of interest, and further includes: wherein the image deflections are selected to direct each of the FOV image beams associated with each of the two or more FOVs along the detector axis.

Example 11 includes the subject matter of any of Examples 1-10, and further specifies that the at least one FOV is two or more FOVs defined based on portions of an image of the ROI of the specimen that include respective features of interest, and that the image deflections are selected to direct each of the FOV image beams associated with each of the two or more FOVs to a common detector area.

Example 12 includes the subject matter of any of Examples 1-11, and further specifies that each of the FOV images is produced by an array detector that defines a plurality of pixels, wherein the CPB is an electron beam and each of the CPB pulses is selected to provide less than 2 electrons to FOV areas associated with respective pixels defined by the array detector.

Example 13 is a method, including: repetitively exposing a FOV on a sample to CPB pulses, wherein the CPB pulses are temporally separated by an FOV relaxation time associated with recoverable sample damage; and imaging the FOV with an array detector defining a plurality of pixels, wherein the CPB pulses are configured so that a number of charged particles from the CPB pulses in an FOV area corresponding to a pixel in the array detector FOV images associated with each of the CPB pulses is less than 10.

Example 14 is a CPB apparatus, including: a CPB source operable to produce multiple CPB pulses directed to each of a plurality of FOVs defined on a sample; and a CPB beam deflector situated to receive the CPB pulses from the CPB source and direct multiple CPB pulses to each of a plurality of FOVs, wherein the multiple CPB pulses applied to each FOV are temporally separated by at least a phonon lifetime associated with the sample.

Example 15 includes the subject matter of Example 14, and further includes a CPB image deflector operable to direct FOV image beams associated with each of the plurality of FOVs defined on the sample along a common axis.

Example 16 includes the subject matter of any of Examples 14-15, and further includes a CPB image deflector wherein the CPB image deflector is operable to direct the FOV image beams to a common area of a CPB image detector.

Example 17 includes the subject matter of any of Examples 14-16, and further specifies that the CPB is an electron beam and further includes a controller operable to direct the CPB source to produce CPB pulses so that each pixel of a CPB array detector is associated with a corresponding portion of the FOV that receives less than 5 electrons in any CPB pulse.

Example 18 includes the subject matter of any of Examples 14-17, and further includes a controller operable to combine FOV images based on each of the FOV image beams to produce an FOV image.

Example 19 includes the subject matter of any of Examples 14-18, and further specifies that the CPB is deflected sequentially to the plurality of FOVs of a region of interest of the sample.

Example 20 is a method, including: repetitively directing an electron beam to at least one field of view of a sample; and imaging the at least one field of view with an array detector that defines a plurality of pixels, wherein the electron beam is configured to effectively expose an FOV area associated with a pixel to no more than a selected number of electrons.

Example 21 includes the subject matter of Example 20, and further specifies that the electron beam is configured to effectively expose the FOV based on a direct electron beam exposure and an evanescent exposure.

In view of the many possible embodiments to which the principles of the disclosed technology may be applied, it should be recognized that the illustrated embodiments are only preferred examples and should not be taken as limiting the scope of the disclosure.

## Claims

1. A method, comprising:
applying multiple CPB pulses to at least one field of view (FOV) defined in a region of interest (ROI) of a specimen, wherein the multiple CPB pulses are applied to the at least one FOV with a temporal separation based on an FOV relaxation time; and
obtaining multiple FOV images of the at least one FOV, each FOV image corresponding to a respective CPB pulse of the multiple CPB pulses.

2. The method of claim 1, wherein the at least one FOV is defined based on a portion of an image of the ROI of the specimen that contains a feature of interest.

3. The method of claim 1, wherein the at least one FOV is two or more FOVs defined based on portions of an image of the ROI of the specimen that include respective features of interest.

4. The method of claim 1, claim 2 or claim 3, further comprising combining, optionally by averaging or summing, the FOV images associated with each of the multiple CPB pulses to produce a combined FOV image.

5. The method of any preceding claim, wherein the multiple CPB pulses applied to the at least one FOV are temporally separated by at least the FOV relaxation time.

6. The method of any preceding claim, wherein the FOV relaxation time is a phonon relaxation time.

7. The method of any preceding claim, further comprising applying CPB deflections to produce the multiple CPB pulses.

8. The method of claim 7, further comprising applying image deflections to FOV image beams associated with the FOV images, the image deflections selected to direct each of the FOV image beams along a detector axis.

9. The method of claim 8, wherein the at least one FOV is two or more FOVs defined based on portions of an image of the ROI of the specimen that include respective features of interest, and further wherein the image deflections are selected to direct each of the FOV image beams associated with each of the two or more FOVs to either along the detector axis or to a common detector area.

10. The method of any preceding claim, wherein each of the FOV images is produced by an array detector that defines a plurality of pixels, wherein the CPB is an electron beam and each of the CPB pulses is selected to provide less than 2 electrons to FOV areas associated with respective pixels defined by the array detector.

11. A CPB apparatus, comprising:
a CPB source operable to produce multiple CPB pulses directed to each of a plurality of FOVs defined on a sample; and
a CPB beam deflector situated to receive the CPB pulses from the CPB source and direct multiple CPB pulses to each of a plurality of FOVs, wherein the multiple CPB pulses applied to each FOV are temporally separated by at least a phonon lifetime associated with the sample.

12. The CPB apparatus of claim 11, further comprising a CPB image deflector operable to direct FOV image beams associated with each of the plurality of FOVs defined on the sample along a common axis, and optionally to a common area of a CPB image detector.

13. The CPB apparatus of claim 11 or claim 12, wherein the CPB is an electron beam, further comprising a controller operable to direct the CPB source to produce CPB pulses so that each pixel of a CPB array detector is associated with a corresponding portion of each of the FOVs that receives an average number or electrons in the CPB pulses of less than 1.

14. The CPB apparatus of claim 12, further comprising a controller operable to combine FOV images based on each of the FOV image beams to produce an FOV image.

15. The CPB apparatus of any one of claims 11-14, wherein the CPB is deflected sequentially to the plurality of FOVs of a region of interest of the sample.
